(19) Europäisches Patentamt
European Patent Office
Office européen des brevets

(11) **EP 1 580 243 B1**

(12) **EUROPEAN PATENT SPECIFICATION**

(45) Date of publication and mention
of the grant of the patent:
**13.05.2009 Bulletin 2009/20**

(51) Int Cl.:
*C09G 1/02* *(2006.01)*        *H05K 3/00* *(2006.01)*
*H01L 21/304* *(2006.01)*        *H05K 3/26* *(2006.01)*

(21) Application number: **05006025.0**

(22) Date of filing: **18.03.2005**

(54) **Polishing composition and polishing method**

Polierzusammensetzung und Polierverfahren

Composition de polissage et procédé de polissage

(84) Designated Contracting States:
**AT BE BG CH CY CZ DE DK EE ES FI FR GB GR
HU IE IS IT LI LT LU MC NL PL PT RO SE SI SK TR**

(30) Priority: **19.03.2004 JP 2004081585**

(43) Date of publication of application:
**28.09.2005 Bulletin 2005/39**

(73) Proprietor: **FUJIMI INCORPORATED**
**Nishikasugai-gun**
**Aichi 452-8502 (JP)**

(72) Inventors:
 • **Tamai, Kazusei**
  **c/o Fujimi Incorporated**
  **Nishikasugai-gun**
  **Aichi 452-8502 (JP)**

 • **Yamato, Yasuyuki**
  **c/o Fujimi Incorporated**
  **Nishikasugai-gun**
  **Aichi 452-8502 (JP)**

(74) Representative: **Reinhard - Skuhra - Weise &
Partner GbR
Patent- und Rechtsanwälte
P.O. Box 440151
80750 München (DE)**

(56) References cited:
**EP-A- 0 747 939**        **EP-B- 1 234 009**

**Description**

BACKGROUND OF THE INVENTION

The present invention relates to a polishing composition used, for example, in polishing for forming conductor wiring for a circuit board, and to a polishing method using such a polishing composition.

In recent years, it has been required that circuit boards such as semiconductor package substrates in which ICs, transistors, and the like are mounted, have various functions and high-performance in connection with the acceleration and high integration of LSIs. A damascene process wherein a chemical mechanical polishing (CMP) technology is used has become the main method for forming conductor wiring for a circuit board. In the case of formation of conductor wiring, first, on a resin section which has trenches, a conductor layer is formed so that at least the trenches is filled with the conductor layer. Then, at least a portion of the conductor layer positioned outside the trenches is removed by polishing so that a portion of the resin section between adjacent trenches is exposed. In this way, at least a part of the portion of the conductor layer positioned inside the trenches remains on the resin section, and the portion of the conductor layer which remains functions as conductor wiring.

A polishing composition disclosed in Japanese Laid-Open Patent Publication No. 2003-257910 is used in polishing for forming conductor wiring. The polishing composition contains abrasive, a copper chelating agent, a copper etching agent, and an oxidizing agent.

EP 747 939 discloses a copper based metal polishing solution comprising a water soluble organic acid capable of reacting with copper to form a copper complex compound which is unlikely to be dissolved in water and has a mechanical strength lower than that of copper. The polishing solution also contains polishing abrasive grains and water.

EP 1 234 009 discloses a composition for planarising or polishing a surface comprising a liquid carrier and solids comprising 5-90 wt.-% of fumed metal oxide and 10-95 wt.-% of abrasive particles, wherein 90% or more of the abrasive particles (by number) have a particle size no greater than 100 nm.

In order to enhance the efficiency of polishing for forming conductor wiring, it is important not only to raise the polishing quantity of a conductor layer per unit time (polishing rate of a conductor layer), but also to raise the polishing quantity of a resin section per unit time (polishing rate of a resin section). Nevertheless, the polishing composition described in Japanese Laid-Open latent Publication No. 2003-257910 can polish a conductor layer in a high stock removal rate, but cannot polish a resin section in a high stock removal rate. Therefore, although the polishing rate of a conductor layer increases when the polishing composition is used in polishing for forming conductor wiring, the polishing rate of a resin section seldom improves.

SUMMARY OF THE INVENTION

Accordingly, an object of the present invention is to provide a polishing composition which can raise the polishing rate of a conductor layer, and the polishing rate of a resin section.

To achieve the foregoing and other objectives and in accordance with the purpose of the present invention, a polishing composition is provided. The polishing composition includes alumina, a complexing agent, and an oxidizing agent. The complexing agent is at least one compound selected from the list comprising α-amino acid, ammonia and an ammonium salt. The polishing composition is used in an application for polishing an object having a resin section with a trench, and a conductor layer provided on the resin section so that at least the trench is filled with the conductor layer,

The present invention also provides a polishing method. The method includes preparing the above polishing composition and polishing an object having a resin section with a trench, and a conductor layer provided on the resin section so that at least the trench is filled with the conductor layer, by using the prepared polishing composition.

Other aspects and advantages of the invention will become apparent from the following description, taken in conjunction with the accompanying drawings, illustrating by way of example the principles of the invention.

BRIEF DESCRIPTION OF THE DRAWINGS

The invention, together with objects and advantages thereof, may best be understood by reference to the following description of the presently preferred embodiments together with the accompanying drawings in which:

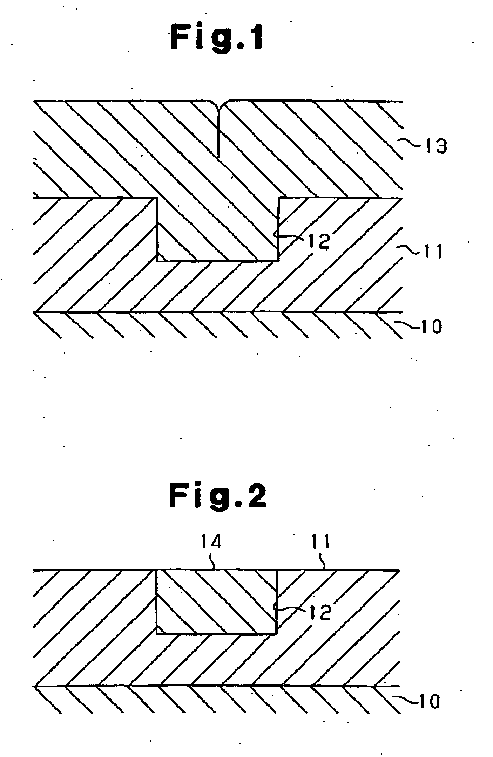

Figs. 1 and 2 are sectional views of an object to be polished for explaining a polishing method according to one embodiment of the present invention.

DETAILED DESCRIPTION OF THE PREFERRED EMBODIMENTS

An embodiment of the present invention will now be described with reference to Figs. 1 and 2.

First of all, a method for forming conductor wiring 14 (refer to Fig. 2) for a wiring board will be explained.

In forming the conductor wiring 14, as shown in Fig. 1, a conductor layer 13 is formed first on an insulating resin layer 11 (resin section) which is provided on a substrate 10 and has trenches 12. The substrate 10 consists of, for example, ceramics or metal. The resin layer 11 may be formed with any of a glass epoxy resin, a polyimide resin, a paper epoxy resin, and a Bakelite resin. The trenches 12 are formed so as to have a predetermined designed pattern, for example, by well-known lithography technology and pattern-etching technology. The conductor layer 13 is formed on the resin layer 11 so as to fill at least the trenches 12. The conductor layer 13 is formed, for example, by PVD, CVD, or plating, and consists of copper containing material such as copper, a copper-aluminum alloy, and a copper-titanium alloy.

Subsequently, at least a portion of the conductor layer 13 positioned outside the trenches 12 is removed by polishing so that the resin layer 11 is exposed. Thereby, at least a part of the portion of the conductor layer 13 positioned inside the trenches 12 remains on the resin section 11, and the portion of the conductor layer 13 which remains functions as conductor wiring 14. As shown in Fig. 2, after polishing, top faces of the conductor wiring 14 and resin layer 11 are exposed. The exposed top faces of the conductor wiring 14 and the resin layer 11 are mutually flush, and both are smooth. Polishing for forming the conductor wiring 14 is performed by one time of polishing step. A polishing composition according to this embodiment contains alumina, a complexing agent, an oxidizing agent, and water, and is used in polishing for forming the conductor wiring 14.

Alumina in the polishing composition has a function of mechanically polishing an object to be polished. Alumina to be contained in the polishing composition may be produced by grinding and classification after heat-treating aluminum hydroxide, or it may be colloidal alumina or fumed alumina. The polishing composition may also contain two types of different alumina.

From the viewpoint of improvement in polishing rates of the conductor layer 13 and resin layer 11, the content of alumina in the polishing composition is preferably 0.1 mass% or more, more preferably 1 mass% or more, further preferably 5 mass% or more, and most preferably 7 mass% or more. On the other hand, from the viewpoint of the improvement of dispersibility and solubility of each component in the polishing composition, the content of alumina is preferably 50 mass% or less, more preferably 30 mass% or less, and most preferably 20 mass% or less.

When the alumina contained in the polishing composition is alumina other than fumed alumina and colloidal alumina, from the viewpoint of improvement in the polishing rate of the resin layer 11, the average particle diameter of the alumina measured by an electric resistance method (a Coulter method) is preferably 0.1 $\mu$m or more, and further preferably 1 $\mu$m or more. On the other hand, from the viewpoint of suppressing scratches (linear flaws) occurring while polishing, the average particle diameter of the alumina measured by the electric resistance method is preferably 50 $\mu$m or less, and more preferably 10 $\mu$m or less.

When the alumina contained in the polishing composition is fumed alumina or colloidal alumina, from the viewpoint of improvement in the polishing rate of the resin layer 11, the average particle diameter of the alumina measured by a laser diffraction method is preferably 0.1 $\mu$m or more. On the other hand, from the viewpoint of suppressing scratches occurring while polishing, the average particle diameter of the alumina measured by the laser diffraction method is preferably 10 $\mu$m or less, and further preferably 1 $\mu$m or less.

The complexing agent in the polishing composition has the function of catching metal generated in the polishing composition by the polishing of the conductor layer 13 and enhancing the polishing of the conductor layer 13. The complexing agent to be contained in the polishing composition may be at least one compound selected from $\alpha$-amino acids, such as glycine and alanine, ammonia, and an ammonium salt. An $\alpha$-amino acid, ammonia, or an ammonium salt has a strong action of enhancing copper polishing when the conductor layer 13 consists of copper.

When only at least one compound selected from between ammonia and an ammonium salt is contained as a complexing agent in the polishing composition, there is a possibility that corrosion may arise on the surface of the conductor layer 13 depending on the content of a complexing agent. Moreover, when only an $\alpha$-amino acid is contained as a complexing agent in the polishing composition, the polishing rate of copper does not become high depending on the content of the complexinq agent in comparison with the case that only at least one compound selected from between the ammonia and ammonium salt is contained as a complexing agent in the polishing composition. Therefore, in order to make the suppression of corrosion of the conductor layer 13 and the improvement in the polishing rate of copper compatible, it is preferable that at least one compound, selected from between the ammonia and ammonium salt, and the $\alpha$-amino acid are contained as the complexing agent in the polishing composition.

What are cited as specific examples of the $\alpha$-amino acids are neutral amino acids such as glycine, alanine, valine, leucine, isoleucine, alloisoleucine, serine, threonine, allothreonine, cysteine, methionine, phenylalanine, tryptophan, thyrosin, proline, and cystine; acidic amino acids such as glutamic acid and aspartic acid; and basic amino acids such as arginine and histidine. At least one compound is used among these. Especially, since procurement is easy and moreover the polishing rate of the conductor layer 13 is improved well, glycine and $\alpha$-alanine acid are preferable, and glycine is more preferable. The $\alpha$-amino acid may be any of an L-enantiomer and a D-enantiomer. When the conductor layer 13 consists of copper, from the viewpoint of improvement in the polishing rate of copper, the content of the $\alpha$-amino

acid in the polishing composition is preferably 0.01 mass% or more, and more preferably 0.1 mass% or more. On the other hand, from the viewpoint of cost effectiveness, the content of the $\alpha$-amino acid is preferably 20 mass% or less, and is more preferably 10 mass% or less.

What are cited as specific examples of the ammonium salts are ammonium salts of inorganic acids such as ammonium carbonate, ammonium hydrogencarbonate, ammonium phosphate, ammonium nitrate, ammonium sulfate, and ammonium chloride; and ammonium salts of organic acids such as ammonium oxalate, ammonium citrate, ammonium succinate and ammonium tartrate. At least one compound is used among these. Since ammonia has an action of polishing an object chemically and does not contain metal impurities, ammonia is preferable to be contained in the polishing composition as the complexing agent. When the conductor layer 13 consists of copper, from the viewpoint of improvement in the polishing rate of copper, sum of the content of the ammonia and ammonium salts in the polishing composition is preferably 0.1 mass% or more, and more preferably 1 mass% or more. On the other hand, from the viewpoint of suppressing corrosion of the conductor layer 13, the content is preferably 10 mass% or less, and more preferably 5 mass% or less.

An oxidizing agent in the polishing composition makes the operation of enhancing the polishing of the conductor layer 13 by chemical polishing. An oxidizing agent to be contained in the polishing composition may be at least one compound selected from persulfuric acid, periodic acid, perchloric acid, peracetic acid, performic acid, nitric acid and a salt thereof, and hydrogen peroxide. Among them, hydrogen peroxide is preferable because hydrogen peroxide little contaminated with metal impurities is inexpensively and easily available.

From the viewpoint of improvement in the polishing rate of the conductor layer 13, the content of the oxidizing agent in the polishing composition is preferably 0.01 mass% or more, more preferably 0.1 mass% or more, and further preferably 0.3 mass% or more. On the other hand, from the viewpoint of cost effectiveness, the content of the oxidizing agent is preferably 10 mass% or less, more preferably 6 mass% or less, and further preferably 3 mass% or less.

Water in the polishing composition acts as a medium for dispersing or dissolving components in the polishing composition. Water to be contained in the polishing composition preferably contains as little impurity as possible so as not to hinder the actions of each component in the polishing composition, and preferably is deionized water, ultra pure water, or distilled water.

From the viewpoint of improvement in the polishing rate of copper, the pH of the polishing composition is preferably 7 or more, more preferably 8.5 or more, and further preferably 9 or more. On the other hand, from the viewpoint of suppressing the corrosion of the conductor layer 13, the pH is preferably less than 12, more preferably less than 11.5, and further preferably less than 11. In addition, when the polishing composition contains at least one compound, selected from ammonia and ammonium salt, and an $\alpha$-amino acid as the complexing agent; it is preferable to set the content of the complexing agent in consideration of the above-mentioned range of the pH.

In order to suppress the aggregation of alumina in the polishing composition and to enhance redispersibility, alumina sol may be added to the polishing composition according to this embodiment, as an aggregation restrainer. When alumina sol is added to the polishing composition, it is possible to suppress the generation of hard caking, which becomes a cause of lowering the redispersibility of alumina, and the aggregation of alumina, which causes scratches generated on the polished object, because of an action of alumina sol dispersed colloidally in the polishing composition. It is possible to obtain alumina sol by dispersing hydrated alumina, such as boehmite, pseudo-boehmite, diaspore, gibbsite, and bayerite, or aluminum hydroxide colloidally in an aqueous acid. Especially, alumina sol obtained by dispersing boehmite or pseudo-boehmite in the aqueous acid is preferable. From the viewpoint of suppressing the aggregation of alumina, the content of alumina sol in the polishing composition is preferably 0.05 mass% or more, or preferably 0.1 mass% or more, and further preferably 0.5 mass% or more. On the other hand, from the viewpoint of the improvement of dispersibility and solubility of each component in the polishing composition, the content of alumina sol is preferably 5 mass% or less, more preferably 3 mass% or less, and further preferably 2 mass% or less.

When polishing for forming the conductor wiring 14 using the polishing composition according to this embodiment is performed, the conductor layer 13 and resin layer 11 are mechanically polished by action of alumina in the polishing composition at a high stock removal rate. Especially, since being enhanced by action of the complexing agent that catches metal generated in the polishing composition by the polishing of the conductor layer 13, and action of the oxidizing agent that has chemical polishing, the polishing of the conductor layer 13 is performed at an especially high stock removal rate. Therefore, according to the polishing composition, it is possible to raise the polishing rate of the conductor layer 13 and the polishing rate of the resin layer 11, and the efficiency of the polishing for forming the conductor wiring 14 improves.

The polishing composition may be prepared by diluting a stock solution with water at the time of use. The stock solution is easy in storage and transportation.

The polishing composition may be stored in the state where an oxidizing agent is separated from the other components. In this case, the polishing composition is provided for use after the oxidizing agent has been mixed with the other components. According to this, the oxidizing agent is prevented from decomposing in the polishing composition during storage.

Into the polishing composition, a well-known additive such as a surfactant, a thickener, an emulsifier, a antirust agent, a preservative, an antifungal agent, an antifoaming agent, and a pH adjuster may be added.

The conductor layer 13 may be provided on a resin substrate (resin section) instead of being provided on the resin layer 11 provided on the substrate 10.

In the next place, Examples and Comparative Examples according to the present invention will be described.

Each of an abrasive, a complexing agent, an oxidizing agent, and alumina sol was mixed to water as required in order to prepare polishing compositions according to Examples 1 to 22 and Comparative Examples 1 to 8. The detail of the abrasive, complexing agent, oxidizing agent, and alumina sol in each polishing composition is as being shown in Table 1. In conjunction with this, measurements of pH of respective polishing compositions are shown in Table 1. Here, the unit of a value which indicates the content of each component in Table 1, is mass%.

Table 1

| | Abrasive | | First complexing agent | | Second complexing agent | | Oxidizing agent | | Alumina Sol | pH |
|---|---|---|---|---|---|---|---|---|---|---|
| | Kind | Content | Kind | Content | Kind | Content | Kind | Content | Content | |
| Ex. 1 | A3 | 20 | G | 0.2 | $NH_3$ | 2 | $H_2O_2$ | 1 | 1.5 | 10.1 |
| Ex. 2 | A3 | 15 | G | 0.2 | $NH_3$ | 2 | $H_2O_2$ | 1 | 1.5 | 10.1 |
| Ex. 3 | A3 | 7 | G | 0.2 | $NH_3$ | 2 | $H_2O_2$ | 1 | 1.5 | 10.1 |
| Ex. 4 | A1 | 15 | G | 0.2 | $NH_3$ | 2 | $H_2O_2$ | 1 | 1.5 | 10.1 |
| Ex. 5 | A2 | 15 | G | 0.2 | $NH_3$ | 2 | $H_2O_2$ | 1 | 1.5 | 10.1 |
| Ex. 6 | CA | 15 | G | 0.2 | $NH_3$ | 2 | $H_2O_2$ | 1 | 1.5 | 10.1 |
| Ex. 7 | FA | 5 | G | 0.2 | $NH_3$ | 2 | $H_2O_2$ | 1 | 1.5 | 10.1 |
| Ex. 8 | A3 | 15 | G | 0.01 | $NH_3$ | 2 | $H_2O_2$ | 1 | 1.5 | 10.1 |
| Ex. 9 | A3 | 15 | G | 3 | $NH_3$ | 2 | $H_2O_2$ | 1 | 1.5 | 10.1 |
| Ex. 10 | A3 | 15 | - | | $NH_3$ | 2 | $H_2O_2$ | 1 | 1.5 | 10.1 |
| Ex. 11 | A3 | 15 | A | 0.2 | $NH_3$ | 2 | $H_2O_2$ | 1 | 1.5 | 10.1 |
| Ex. 12 | A3 | 15 | G | 0.2 | $NH_3$ | 0.1 | $H_2O_2$ | 1 | 1.5 | 9.2 |
| Ex. 13 | A3 | 15 | G | 0.2 | $NH_3$ | 5 | $H_2O_2$ | 1 | 1.5 | 10.9 |
| Ex. 14 | A3 | 15 | G | 0.2 | - | | $H_2O_2$ | 1 | 1.5 | 7.3 |
| Ex. 15 | A3 | 15 | G | 0.2 | $NH_3$ | 2 | $H_2O_2$ | 0.1 | 1.5 | 10.1 |
| Ex. 16 | A3 | 15 | G | 0.2 | $NH_3$ | 2 | $H_2O_2$ | 0.2 | 1.5 | 10.1 |
| Ex. 17 | A3 | 15 | G | 0.2 | $NH_3$ | 2 | $H_2O_2$ | 0.5 | 1.5 | 10.1 |
| Ex. 18 | A3 | 15 | G | 0.2 | $NH_3$ | 2 | $H_2O_2$ | 5 | 1.5 | 10.1 |
| Ex. 19 | A3 | 15 | G | 0.2 | $NH_3$ | 2 | APS | 1 | 1.5 | 10.1 |
| Ex. 20 | A3 | 15 | G | 0.2 | $NH_3$ | 2 | $H_2O_2$ | 1 | - | 10.1 |
| Ex.21 | A3 | 15 | G | 0.2 | $NH_3$ | 2 | $H_2O_2$ | 1 | 0.015 | 10.1 |
| Ex. 22 | A3 | 15 | G | 0.2 | $NH_3$ | 2 | $H_2O_2$ | 1 | 0.15 | 10.1 |
| C. Ex. 1 | A3 | 0.5 | G | 0.2 | $NH_3$ | 2 | $H_2O_2$ | 1 | 1.5 | 10.1 |
| C. Ex. 2 | A3 | 3 | G | 0.2 | $NH_3$ | 2 | $H_2O_2$ | 1 | 1.5 | 10.1 |
| C. Ex. 3 | - | | G | 0.2 | $NH_3$ | 2 | $H_2O_2$ | 1 | 1.5 | 10.1 |
| C. Ex.4 | CS | 15 | G | 0.2 | $NH_3$ | 2 | $H_2O_2$ | 1 | 1.5 | 10.1 |
| C. Ex. 5 | FS | 15 | G | 0.2 | $NH_3$ | 2 | $H_2O_2$ | 1 | 1.5 | 10.1 |
| C. Ex. 6 | A3 | 15 | - | | - | | $H_2O_2$ | 1 | 1.5 | 7.3 |
| C. Ex. 7 | A3 | 15 | - | | - | | - | | 1.5 | 7.3 |

(continued)

|  | Abrasive | | First complexing agent | | Second complexing agent | | Oxidizing agent | | Alumina Sol | pH |
|---|---|---|---|---|---|---|---|---|---|---|
|  | Kind | Content | Kind | Content | Kind | Content | Kind | Content | Content |  |
| C. Ex. 8 | A3 | 15 | G | 0.2 | $NH_3$ | 2 | | - | 1.5 | 10.1 |

In the column entitled "Abrasive" of Table 1,

"A1" denotes alumina with the average particle diameter of 1.3 $\mu$m,
"A2" denotes alumina with the average particle diameter of 3.0 $\mu$m,
"A3" denotes alumina with the average particle diameter of 5.5 $\mu$m,
"CA" denotes colloidal alumina with the average particle diameter of 0.05 $\mu$m,
"FA" denotes fumed alumina with the average particle diameter of 0.2 $\mu$m,
"CS" denotes colloidal silica with the average particle diameter of 0.07 $\mu$m, and
"FS" denotes fumed silica with the average particle diameter of 0.2 $\mu$m.

The average particle diameter of alumina was measured by the electric resistance method using "Coulter Multisizer" made by Beckman Coulter Inc., and the average particle diameters of colloidal alumina, fumed alumina, colloidal silica, and fumed silica were measured by the laser diffraction method using "N4 Plus Submicron Particle Sizer" made by Beckman Coulter Inc.

In the columns entitled "First complexing agent" and "Second complexing agent" of Table 1,

"G" denotes glycine,
"A" denotes alanine, and
"$NH_3$" denotes ammonia.

In the column entitled "Oxidizing agent" of Table 1,

"$H_2O_2$" denotes hydrogen peroxide, and
"APS" denotes ammonium sulfite.

A copper blanket-wafer and an epoxy resin blanket-wafers were polished for 1 minute under the following polishing conditions using respective polishing compositions according to Examples 1 to 22 and Comparative Examples 1 to 8. Then, the polishing rate of copper and the polishing rate of epoxy resin were found on the basis of the following formulae. The results are shown in the column entitled "Polishing rate" of Table 2. In addition, each copper blanket-wafer has a copper film formed on an 8-inch silicon wafer with an electroplating method, and each epoxy resin blanket-wafer has a film consisting of an epoxy resin (ABF by Ajinomoto Co., Inc.) on an 8-inch silicon wafer with spin coating.

<Polishing conditions>

Polishing apparatus: single-sided CMP polishing machine, "ARW" made by MAT Corporation,
[0042] Polishing pad: multilayered polishing pad "IC-1000/Suba400" made of polyurethane and made by Rodel Corporation,

Polishing pressure: 28 kPa (about 6 psi),
Rotational frequency of press platen: 90 min$^{-1}$,
Feed rate of polishing composition: 140 mL/min,
Rotational frequency of carrier for supporting wafer: 95 min$^{-1}$

<Formula of polishing rate of copper>

$$\text{Polishing rate of copper } [\mu m/min] = (\text{thickness of copper}$$
$$\text{blanket-wafer before polishing } [\mu m] - \text{thickness of copper}$$
$$\text{blanket-wafer after polishing } [\mu m])/\text{polishing time } [min].$$

In addition, the thickness of the copper blanket-wafers before and after polishing was measured using a sheet resistance measuring instrument, "VR-120" made by Kokusai Electric system service Co., Ltd.

<Formula of polishing rate of epoxy resin>

$$\text{Polishing rate of epoxy resin } [\mu m/min] = (\text{weight of}$$
$$\text{epoxy resin blanket-wafer before polishing } [g] - \text{weight of}$$
$$\text{epoxy resin blanket-wafer after polishing } [g]) / \text{specific}$$
$$\text{gravity of epoxy resin } [g/cm^3] / \text{polishing area of epoxy resin}$$
$$\text{blanket-wafer } [cm^2] / \text{polishing time } [min]$$

Patterned wafers which each had a copper conductor layer on a resin layer which was made of an epoxy resin and had trenches were prepared. The trenches include a trench with the depth of 20 $\mu$m and the width of 85 $\mu$m, a trench with the depth of 20 $\mu$m and the width of 300 $\mu$m, and a trench with the depth of 20 $\mu$m and the width of 500 $\mu$m. The patterned wafers were polished under the above-mentioned polishing conditions until a top face of a portion of each resin layer between adjacent trenches was exposed using each of the polishing compositions according to Examples 1 to 22 and Comparative Examples 1 to 8. The time taken for the top face of the portion of each resin layer to be exposed is shown in the column entitled "Removing time" of Table 2.

Dishing depth was measured in a region (TiJBS), in which a trench with the width of 85 $\mu$m is formed, a region (W300), in which a trench with the width of 300 $\mu$m is formed, and a region (W500), in which a trench with the width of 500 $\mu$m is formed, in each of the patterned wafers after polished using each polishing composition according to Examples 1 to 22 and Comparative Examples 1 to 8. The results are shown in the column entitled "Dishing depth" of Table 2. The measurement of the dishing depth was performed using a profiler "HRP340" which is a contact type surface measurement apparatus made by KLA-Tencor Corporation. In addition, that the plus value of the dishing depth means that the portion of the conductor layer positioned inside the trench is depressed, and the minus value of the dishing depth means that the portion of the conductor layer positioned inside the trench protrudes.

The redispersibility of abrasives was evaluated as follows using each of the polishing compositions according to Examples 1 to 22 and Comparative Examples 1 to 8 which were charged in vessels made of polypropylene, and which were left as it is for ten days. Thus, they were evaluated to be excellent (E) when there was no precipitate or when precipitates disappeared by shaking within 1 minute even if the precipitates were in each polishing composition after having been left as it is for ten days, to be good (G) when the precipitates disappeared by shaking for 1 to 10 minutes, and to be defective (D) when the precipitates did not disappear even by shaking for 10 minutes or more. The results are shown in the column entitled "Redispersibility" of Table 2.

Table 2

| | Polishing rate [$\mu$m/min] | | Removing time [sec] | Dishing depth [$\mu$m] | | | Redispersibility |
|---|---|---|---|---|---|---|---|
| | Copper | Epoxy resin | | W300 | W500 | W85 | |
| Ex. 1 | 5.2 | 6.7 | 150 | -0.5 | -0.7 | -0.7 | E |
| Ex. 2 | 7.1 | 6.2 | 120 | 0.4 | -0.3 | -0.3 | E |
| Ex. 3 | 5.2 | 2.1 | 150 | 1.5 | 1.8 | 1.3 | E |
| Ex. 4 | 5.1 | 3.7 | 150 | 0.3 | 0.3 | 0.3 | E |
| Ex. 5 | 6.2 | 5 | 150 | 0.8 | 1.0 | 1.1 | E |

(continued)

| | Polishing rate [μm/min] | | Removing time [sec] | Dishing depth [μm] | | | Redispersibility |
|---|---|---|---|---|---|---|---|
| | Copper | Epoxy resin | | W300 | W500 | W85 | |
| Ex. 6 | 6.5 | 4.5 | 150 | 1.0 | 0.8 | 0.8 | E |
| Ex. 7 | 6.7 | 5 | 150 | 1.2 | 1.0 | 0.9 | E |
| Ex. 8 | 5.0 | 6.2 | 150 | -0.5 | -0.5 | -0.3 | E |
| Ex. 9 | 7.6 | 6.2 | 120 | 0.5 | 0.4 | 0.3 | E |
| Ex. 10 | 5.2 | 6.2 | 150 | -0.6 | -0.4 | -0.5 | E |
| Ex. 11 | 5.3 | 5.9 | 150 | -0.7 | -0.6 | -0.6 | E |
| Ex. 12 | 4.2 | 6.2 | 180 | -1.0 | -0.8 | -1.0 | E |
| Ex. 13 | 6.6 | 6.2 | 150 | 0.5 | 0.3 | 0.3 | E |
| Ex. 14 | 4.1 | 6.2 | 180 | -0.9 | -0.9 | -1.1 | E |
| Ex. 15 | 3.1 | 6.2 | 180 | -1.5 | -1.7 | -1.5 | E |
| Ex. 16 | 4.2 | 6.2 | 180 | -1.1 | -0.8 | -0.7 | E |
| Ex. 17 | 5.4 | 6.2 | 150 | -0.8 | -0.8 | -0.9 | E |
| Ex. 18 | 5.3 | 6.2 | 150 | -0.3 | -0.6 | -0.6 | E |
| Ex. 19 | 3.1 | 6.2 | 180 | -1.6 | -2.0 | -1.5 | E |
| Ex. 20 | 6.9 | 5.9 | 120 | 0.5 | -0.3 | -0.3 | D |
| Ex. 21 | 7.1 | 6.2 | 120 | 0.4 | -0.3 | -0.3 | G |
| Ex. 22 | 7.1 | 6.2 | 120 | 0.4 | -0.3 | -0.3 | G |
| C. Ex. 1 | 4.8 | 0 | 150 | 4.7 | 4.4 | 4.8 | E |
| C. Ex. 2 | 5.0 | 0 | 150 | 5.1 | 4.6 | 4.5 | E |
| C. Ex. 3 | 2.5 | 0 | 180 | 3.5 | 3.3 | 2.8 | E |
| C. Ex. 4 | 4.7 | 0.2 | 150 | 5.1 | 4.6 | 4.5 | E |
| C. Ex. 5 | 4.5 | 0.3 | 150 | 4.8 | 4.1 | 3.9 | E |
| C. Ex. 6 | 0.6 | 6.2 | 180 | -3.3 | -3.8 | -4.3 | E |
| C. Ex. 7 | 0.9 | 6.2 | 240 | -3.5 | -4.2 | -3.8 | E |
| C. Ex. 8 | 1.4 | 6.2 | 150 | -1.5 | -2 | -2 | E |

As shown in Table 2, in Examples 1 to 22, the polishing rate of copper was high, that is, 3.0 μm/min or more, and the polishing rate of epoxy resin was also high, that is, 2.0 μm/min or more. On the other hand, in Comparative Examples 1 to 8, the polishing rate of copper was less than 3.0 μm/min, or the polishing rate of epoxy resin was less than 2.0 μm/min. A reason why the polishing rate is low in Comparative Examples 1 and 2 is that the content of alumina in each polishing composition of Comparative Examples 1 and 2 is small. In additi.on, a reason why the polishing rate is low in Comparative Examples 3 to B is that each polishing composiLion of Comparative Examples 3 to 8 does not contain at least one among an abrasive, a complexing agent, and an oxidizing agent.

In order to obtain a favorable result about the removing time and dishing depth, it was found that it was preferable to set the content of alumina at nearly 15 mass% from the results of Examples 1 to 3, to set the content of the α-amino acid at 0.2 mass% or more from the results of Examples 2, 8, and 9, to set the content of ammonia at nearly 2 mass% from the results of Examples 2, 12, and 13, to use both the α-amino acid and ammonia as complexing agents from the results of Examples 13 and 14, and to set the content of hydrogen peroxide at nearly 1 mass% from the results of Examples 2, 15 to 18. From the results of Examples 2 and 11, it was confirmed that copper polishing is especially enhanced when glycine was used as a complexing agent. From the results of Examples 2, 20 to 22, it was confirmed that redispersibility is especially favorable when the content of alumina sol was set at 1.5 mass% or more.

**Claims**

1. A polishing composition for use in an application for polishing an object having a resin section with a trench, and a conductor layer provided on the resin section so that at least the trench is filled with the conductor layer, the polishing composition **characterized by** alumina, a complexing agent, and an oxidizing agent, wherein the complexing agent is at least one compound selected from an $\alpha$-amino acid, ammonia, and an ammonium salt.

2. The polishing composition according to claim 1, **characterized in that** the resin section is a resin layer provided on a substrate.

3. The polishing composition according to claim 1 or 2, **characterized in that** the complexing agent is an $\alpha$-amino acid and at least one compound selected from ammonia and an ammonium salt.

4. The polishing composition according to claim 3, **characterized in that** the content of an $\alpha$-amino acid in the polishing composition is 0.01 to 20 mass%.

5. The polishing composition according to claim 3 or 4, **characterized in that** the content of at least one compound selected from ammonia and an ammonium salt in the polishing composition is 0.1 to 10 mass%.

6. The polishing composition according to any one of claims 1 to 5, further **characterized by** alumina sol.

7. The polishing composition according to any one of claims 1 to 6, wherein a pH of the polishing composition is 7 or more.

8. The polishing composition according to any one of claims 1 to 7, **characterized in that** the $\alpha$-amino acid is at least one compound selected from glycine, alanine, valine, leucine, isoleucine, alloisoleucine, serine, threonine, allothreonine, cysteine, methionine, phenylalanine, tryptophan, thyrosin, proline, cystine, glutamic acid, aspartic acid, arginine and histidine.

9. The polishing composition according to any one of claims 1 to 8, **characterized in that** the ammonium salt is at least one compound selected from ammonium carbonate, ammonium hydrogencarbonate, ammonium phosphate, ammonium nitrate, ammonium sulfate, ammonium chloride, ammonium oxalate, ammonium citrate, ammonium succinate, and ammonium tartrate.

10. The polishing composition according to any one of claims 1 to 9, **characterized in that** the oxidizing agent is at least one compound selected from persulfuric acid, periodic acid, perchloric acid, peracetic acid, performic acid, nitric acid and a salt thereof, and hydrogen peroxide.

11. A polishing method **characterized by**:

    preparing the polishing composition according to any one of claims 1 to 10; and
    polishing the object by using the prepared polishing composition.

**Patentansprüche**

1. Polierzusammensetzung zur Verwendung in einer Anwendung zum Polieren eines Objektes, das einen Harzabschnitt mit einem Graben und eine Leiterschicht besitzt, die auf dem Harzabschnitt bereitgestellt ist, so dass mindestens der Graben mit der Leiterschicht gefüllt ist, wobei die Polierzusammensetzung **gekennzeichnet ist durch** Aluminiumoxid, einen Komplexbildner und ein Oxidationsmittel, wobei der Komplexbildner mindestens eine Verbindung ist, ausgewählt aus einer $\alpha$-Aminosäure, Ammoniak und einem Ammoniumsalz.

2. Polierzusammensetzung gemäß Anspruch 1, **dadurch gekennzeichnet, dass** der Harzabschnitt eine Harzschicht ist, die auf einem Substrat vorgesehen ist.

3. Polierzusammensetzung gemäß Anspruch 1 oder 2, **dadurch gekennzeichnet, dass** der Komplexbildner eine $\alpha$-Aminosäure und mindestens eine Verbindung ist, ausgewählt aus Ammoniak und einem Ammoniumsalz.

4. Polierzusammensetzung gemäß Anspruch 3, **dadurch gekennzeichnet, dass** der Gehalt an $\alpha$-Aminosäuren in

der Polierzusammensetzung von 0,01 bis 20 Gew.-% beträgt.

5. Polierzusammensetzung gemäß Anspruch 3 oder 4, **dadurch gekennzeichnet, dass** der Anteil der mindestens einen Verbindung, ausgewählt aus Ammoniak und einem Ammoniumsalz, in der Polierzusammensetzung von 0,1 bis 10 Gew.-% beträgt.

6. Polierzusammensetzung gemäß einem der Ansprüche 1-5, des Weiteren **gekennzeichnet durch** Alumiminiumoxid-Sol.

7. Polierzusammensetzung gemäß einem der Ansprüche 1-6, wobei ein pH der Polierzusammensetzung 7 oder mehr beträgt.

8. Polierzusammensetzung gemäß einem der Ansprüche 1-7, **dadurch gekennzeichnet, dass** die $\alpha$-Aminosäure mindestens eine Verbindung ist, ausgewählt aus Glycin, Alanin, Valin, Leucin, Isoleucin, Alloisoleucin, Serin, Threonin, Allothreonin, Cystein, Methionin, Phenylalanin, Tryptophan, Tyrosin, Prolin, Cystin, Glutaminsäure, Asparagin, Arginin und Histidin.

9. Polierzusammensetzung gemäß einem der Ansprüche 1-8, **dadurch gekennzeichnet, dass** das Ammoniumsalz mindestens eine Verbindung ist, ausgewählt aus Ammoniumcarbonat, Ammoniumhydrogencarbonat, Ammoniumphosphat, Ammoniumnitrat, Ammoniumsulfat, Ammoniumchlorid, Ammoniumoxalat, Ammoniumcitrat, Ammoniumsuccinat und Ammoniumtartrat.

10. Polierzusammensetzung gemäß einem der Ansprüche 1-9, **dadurch gekennzeichnet, dass** Oxidationsmittel mindestens eine Verbindung ist, ausgewählt aus Perschwefelsäure, Periodsäure, Perchlorsäure, Peressigsäure, Perameisensäure, Salpetersäure und einem Salz dieser, und Wasserstoffperoxid.

11. Polierverfahren, **gekennzeichnet durch**:

Bereitstellen der Polierzusammensetzung gemäß einem der Ansprüche 1-10; und Polieren des Objekts unter Verwendung der hergestellten Polierzusammensetzung.


**Revendications**

1. Composition de polissage à utiliser dans une application pour polir un objet ayant une section en résine avec une tranchée et une couche conductrice ménagée sur la section en résine de sorte qu'au moins la tranchée soit remplie avec la couche conductrice, la composition de polissage étant **caractérisée par** l'alumine, un agent complexant, et un agent oxydant, dans lesquels l'agent oxydant est au moins un composé choisi parmi un acide $\alpha$-aminé, l'ammoniac et un sel d'ammonium.

2. Composition de polissage selon la revendication 1, **caractérisée en ce que** la section en résine est une couche de résine ménagée sur un substrat.

3. Composition de polissage selon la revendication 1 ou 2, **caractérisée en ce que** l'agent complexant est un acide $\alpha$-aminé, et au moins un composé choisi parmi l'ammoniac et un sel d'ammonium.

4. Composition de polissage selon la revendication 3, **caractérisée en ce que** la teneur en acide $\alpha$-aminé dans la composition de polissage est de 0,01 à 20 % en masse.

5. Composition de polissage selon la revendication 3 ou 4, **caractérisée en ce que** la teneur en au moins un composé choisi parmi l'ammoniac et un sel d'ammonium, dans la composition de polissage, est de 0,1 à 10 % en masse.

6. Composition de polissage selon l'une quelconque des revendications 1 à 5, **caractérisée en outre par** un sol d'alumine.

7. Composition de polissage selon l'une quelconque des revendications 1 à 6, dans laquelle le pH de la composition de polissage est de 7 ou plus.

**8.** Composition de polissage selon l'une quelconque des revendications 1 à 7, **caractérisée en ce que** l'acide α-aminé est au moins un composé choisi parmi la glycine, l'alanine, la valine, la leucine, l'isoleucine, l'alloisoleucine, la sérine, la thréonine, l'allothréonine, la cystéine, la méthionine, la phénylalanine, le tryptophane, la thyrosine, la proline, la cystine, l'acide glutamique, l'acide aspartique, l'arginine et l'histidine.

**9.** Composition de polissage selon l'une quelconque des revendications 1 à 8, **caractérisée en ce que** le sel d'ammonium est au moins un composé choisi parmi le carbonate d'ammonium, l'hydrogènecarbonate d'ammonium, le phosphate d'ammonium, le nitrate d'ammonium, le sulfate d'ammonium, le chlorure d'ammonium, l'oxalate d'ammonium, le citrate d'ammonium, l'ammonium d'acide succinique, et le tartrate d'ammonium.

**10.** Composition de polissage selon l'une quelconque des revendications 1 à 9, **caractérisée en ce que** l'agent oxydant est au moins un composé choisi parmi l'acide persulfurique, l'acide périodique, l'acide perchlorique, l'acide peracétique, l'acide performique, l'acide nitrique et un sel de ceux-ci, et le peroxyde d'hydrogène.

**11.** Procédé de polissage **caractérisé par** :

la préparation de la composition de polissage selon l'une quelconque des revendications 1 à 10 ; et
le polissage de l'objet en utilisant la composition de polissage préparée.

# Fig.1

~13

~12

~11

~10

# Fig.2

14

11

~12

~10

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2003257910 A
- EP 747939 A
- EP 1234009 A